# EUROPEAN PATENT APPLICATION

(11) **EP 3 047 937 A1**
(43) Date of publication of application: **27.07.2016**
(21) Application number: 14845104.0
(22) Date of filing: 27.08.2014
(51) Int. Cl.: B23K 35/26, C22C 1/02, C22C 12/00, H01L 21/52, H05K 3/34

(54) **Bi GROUP SOLDER ALLOY, METHOD FOR BONDING ELECTRONIC PART USING SAME, AND ELECTRONIC PART MOUNTING SUBSTRATE**

(30) Priority: 20.09.2013 JP 2013195305; 25.10.2013 JP 2013221843; 19.11.2013 JP 2013238722
(71) Applicant: Sumitomo Metal Mining Co., Ltd., Tokyo 105-8716 (JP)
(72) Inventor: NAGATA Hiroaki, Ome-shi Tokyo 198-8601 (JP)
(74) Representative: Müller-Boré & Partner Patentanwälte PartG mbB
(86) International application number: PCT/JP2014/072397
(87) International publication number: WO 2015/041018

(57) **Abstract**

Provided is a Bi-based solder alloy containing a specific amount of Al in Bi-Ag and having particles including a Ag-Al intermetallic compound dispersed therein, a method of bonding a Ag-plated electronic component, a bare Cu frame electronic component, an Ni-plated electronic component, or the like using the same, and an electronic component-mounted board.

A Bi-based solder alloy includes Ag and Al, is substantially free of Pb, and has a Bi content of 80 mass% or more, a solidus of a melting point of 265°C or more, and a liquidus of 390°C or less. A content of Ag is 0.6 to 18 mass%, a content of Al is 0.1 to 3 mass%, the content of Al is 1/20 to 1/2 of the content of Ag, and particles including a Ag-Al intermetallic compound are dispersed in the solder alloy.

## Description

### Technical Field

The present invention relates to a Bi-based solder alloy, a method of bonding an electronic component using the same, and an electronic component-mounted board. More specifically, the present invention relates to a Bi solder alloy that is substantially free of Pb, has a solidus temperature of 265 °C or more and a liquidus temperature of 390°C or less, and is excellent in machinability, mechanical strength, and joint reliability, a method of bonding a Ag-plated electronic component, a bare Cu frame electronic component, a Ni-plated electronic component, or the like using the same, and an electronic component-mounted board.

### Background Art

Typically, an electronic component, such as a semiconductor device chip, is mounted on a printed board, such as a semiconductor package, by first joining (die-bonding) the electronic component to a lead frame using a solder and then remelting (reflow) the solder.

A Sn/37mass%Pb eutectic solder (melting point 183°C) has been widely used as a mid-low-temperature solder so as to mount an electronic component on a board. During mounting, reflow is performed at 220 to 230°C. On the other hand, when making a joint inside an electronic component, a Pb/5mass%Sn solder (solidus temperature 305°C) or Pb/3mass%Sn solder (solidus temperature 315°C) has been used as a high-temperature solder having a higher solidus temperature than the reflow temperature (220 to 230°C) during mounting so as to prevent a j oint failure caused by remelting of the solder at the reflow temperature during mounting.

However, there has been pointed out the risk that after products using a lead (Pb)-containing solder are discarded, Pb could leak from the products, infiltrate into the soil, accumulate in produce and the like, and pose health hazards to humans. It has been also pointed out that the leakage of Pb from discarded products could be accelerated due to acid rain. For these reasons, Pb-free solders have been actively developed in recent years.

As alternatives to mid-low-temperature Pb-containing solders, Pb-free solders, such as a Sn-Ag-Cu solder, have been commercialized.

However, with regard to Pb-free solders, such as a Sn-Ag-Cu solder, the melting point is about 220°C, which is higher than that of a conventional Pb/Sn eutectic solder, and the reflow temperature duringmounting is around 250 to 260°C. For this reason, there is a need for a high-temperature Pb-free solder that does not cause a joint reliability problem or the like inside an electronic component even after a cycle in which the solder is held at a reflow temperature of 260°C for 10 seconds is repeated five times or so (Patent Literature 1).

Specifically, a high-temperature Pb-free solder is required to have properties, such as heat dissipation ability, stress relaxation ability, thermal fatigue resistance, and electrical conductivity, as well as is required to have a higher solidus temperature than at least 260°C so as to prevent a joint failure caused by the remelting of the solder at the reflow temperature (that is, 250 to 260°C) during mounting. Considering variations (5°C or so) in the reflow temperature, the solidus temperature is required to be 265°C or more.

On the other hand, if a Pb-free solder has a solidus temperature of 400°C or more, the working temperature during die bonding must be increased to 400°C or more. Consequently, adverse effects may occur, including changes in chip properties and the promotion of oxidation of the members. Accordingly, the liquidus temperature must be lower than 400°C. Considering the actual production process, the liquidus temperature is preferably 390°C or less, more preferably 350°C or less.

Solders proposed as Pb-free solders having melting points of 265°C to 390°C include Au-Sn solders and Bi-Ag solders. Au-Sn solders have a melting point of 280°C and do not cause a problem associated with remelting during mounting. However, Au-Sn solders are expensive and are not practical in terms of cost. Accordingly, more types of Bi-Ag solders have been proposed than those of Au-Sn solders.

A Bi/2.5mass%Ag eutectic solder (melting point 262°C) is one of representative Bi-Ag solders. However, this type of solder has a solidus temperature of less than 265°C and therefore may cause a problem associated with remelting during mounting. This solder also has brittle mechanical properties specific to Bi solders. Accordingly, direct use of this solder has adverse effects on joint reliability, machinability, and the possibility of continuous supply by a device.

Patent Literature 2 discloses a Bi/Ag solder containing 30 to 80 mass% of Bi. However, this type of solder has a solidus temperature of 262°C and may be remelted. Further, this solder has a high liquidus temperature of 400 to 700°C and therefore may have adverse effects, such as changes in chip properties and the promotion of oxidation of the members.

Patent Literature 3 discloses a method for producing a multi-element solder containing Bi and states that it is possible to produce a high-temperature solder material having a liquidus temperature varying to a lesser extent and a melting point of 250 to 300°C. However, Patent Literature 3 includes no description about an improvement to the brittle properties specific to Bi-based solders.

Patent Literature 4 proposes a solder alloy that contains Al and Cu, as well as Sn in Bi. However, the addition of Sn forms a layer having a low melting point of 139°C, which may be remelted during reflow at 260°C.

In practice, a high-temperature Pb-free solder is required to have sufficient reliability against thermal stress applied to the soldered joint by a large current or a large amount of heat in a power device or the like, machinability into a preformed solder (preform solder), such as a solder wire, and the usability of continuous supply by a device. On the other hand, conventional Bi-Ag solders are supplied only in past form due to the brittle mechanical properties thereof and are insufficient to serve as alternative preform solders in many respects. Accordingly, improvements thereto have been demanded.

Lead frame islands to be coated with a solder alloy may be previously Ag-plated. In the case of car-mounted devices, on the other hand, lead frame islands have been often Ni-plated rather than being Ag-plated in recent years. The reason is that Ni plating allows for the suppression of the growth of a joint interface reaction layer between Ni and the solder in a temperature cycle test or the like for examining reliability and thus increases long-term joint reliability.

However, Ni-plating a lead frame island to be coated with a solder alloy causes problems, including a reduction in the wettability of the solder and a reduction in joint strength resulting from an insufficient joint. For this reason, there is a demand to improve a solder alloy for Ni-plated electronic components so that a reduction in the wettability of the solder and a reduction in joint strength after joining are prevented.

On the other hand, there is a case in which subjection of a lead frame island to a treatment, such as Ag plating or Ni plating, is avoided to reduce cost. This process is called a bare Cu frame and is often used in general-purpose devices, such as transistors. In this case, the wetting spread of the solder over the bare Cu frame is believed to be important.

On the other hand, when a lead frame island which is a bare Cu frame is coated with a solder alloy, Cu starts to preferentially react with a particular element in the solder, for example, Sn. Since the lead frame island has an oxide film thereon, the solder is more likely to wet and spread poorly. Further, Cu is hardly dissolved in a Bi-based solder alloy or Pb-based solder alloy. Accordingly, such a solder alloy tends to wet and spread poorly compared to when Ag plating is performed. That is, a bare Cu frame has a problem that the oxidation of the surface readily proceeds and the solder is more likely to wet and spread poorly thereover due to the influence of the surface roughness. For this reason, there has been a demand to improve a solder alloy so that it is prevented from wetting and spreading poorly when bonded to a bare Cu frame.

### Citation List

### Patent Literature

[Patent Literature 1] Japanese Unexamined Patent Application Publication No. 2002-321084
[Patent Literature 2] Japanese Unexamined Patent Application Publication No. 2002-160089
[Patent Literature 3] Japanese Unexamined Patent Application Publication No. 2006-167790
[Patent Literature 4] Japanese Unexamined Patent Application Publication No. 2012-066270

### Summary of Invention

### Technical Problem

In view of the problems with the conventional art, an object of the present invention is to provide a Bi solder alloy that is substantially free of Pb, has a solidus temperature of 265°C or more and a liquidus temperature of 390°C or less, and is excellent in machinability, mechanical strength, and joint reliability, a method of bonding a Ag-plated electronic component, a bare Cu frame electronic component, a Ni-plated electronic component, or the like using the same, and an electronic component-mounted board. Solution to Problem

To solve the above problems, the present inventor conducted intensive researches. As a result, the present inventor found that when a specific amount of Al was mixed with a conventional Bi-Ag solder to produce an alloy and thus particles including a Ag-Al intermetallic compound were dispersed in the solder alloy, there could be obtained a Bi-based solder alloy that prevented an electronic component from being degraded or damaged by heat during bonding or prevented a remelting problem from being caused by heat during reflow and that had high joint reliability, and then completed the present invention.

The present inventor also found that addition of P or Ge to this Bi-Ag-Al solder alloy allowed the solder alloy to wet and spread over a bare Cu frame better and thus could join the bare Cu frame to the electronic component with sufficient strength. The present inventor also found that addition of Sn or Zn to the Bi-Ag-Al solder alloy allowed the solder alloy to be applied to even a Ni-plated lead frame island without reducing the wettability thereof and thus could join the lead frame island to the electronic component with sufficient strength.

A first aspect of the present invention provides a Bi-based solder alloy that includes Ag and Al, is substantially free of Pb, and has a Bi content of 80 mass% or more, a solidus of a melting point of 265°C or more, and a liquidus of 390°C or less. A content of Ag is 0.6 to 18 mass%, a content of Al is 0.1 to 3 mass%, the content of Al is 1/20 to 1/2 of the content of Ag, and particles including a Ag-Al intermetallic compound are dispersed in the solder alloy.

A second aspect of the present invention provides a Bi-based solder alloy that includes Ag and Al, is substantially free of Pb, and has a Bi content of 80 mass% or more, a solidus of a melting point of 265°C or more, and a liquidus of 390°C or less. A content of Ag is 0.6 to 18 mass%, a content of Al is 0.1 to 3 mass%, the content of Al is 1/20 to 1/2 of the content of Ag, and particles including a Ag-Al intermetallic compound are dispersed in the solder alloy. The Bi-based solder alloy further includes one or more of P and Ge in 0.001 to 0.3 mass%.

A third aspect of the present invention provides a Bi-based solder alloy that includes Ag and Al, is substantially free of Pb, and has a Bi content of 80 mass% or more, a solidus of a melting point of 265°C or more, and a liquidus of 390°C or less. A content of Ag is 0.6 to 18 mass%, a content of Al is 0.1 to 3 mass%, the content of Al is 1/20 to 1/2 of the content of Ag, and particles including a Ag-Al intermetallic compound are dispersed in the solder alloy. The Bi-based solder alloy further includes one or more of Sn and Zn in 0.01 to 3 mass%.

According to a fourth aspect of the present invention, in the Bi-based solder alloy of any one of the first to third aspects, 97 volume% or more of particles with respect to a total volume of all the particles have diameters of less than 50 µm.

According to a fifth aspect of the present invention, in the Bi-based solder alloy of any one of the first to third aspects, the content of Al is 1/15 to 1/4 of the content of Ag.

According to a sixth aspect of the present invention, the Bi-based solder alloy of any one of the first to third aspects further includes one or more selected from Te, Ni, and Cu in 0.01 to 1 mass%.

According to a seventh aspect of the present invention, the Bi-based solder alloy of the third aspect includes P or Ge in 0.001 to 0.3 mass%.

According to an eighth aspect of the present invention, in the Bi-based solder alloy of any one of the first to third aspects, the particles including the Ag-Al intermetallic compound are dispersed in the alloy by pouring molten metal of the solder alloy into a mold and then quickly cooling and solidifying the molten metal to 260°C at a cooling speed of 3°C/sec or more.

A ninth aspect of the present invention provides a method for bonding an electronic component comprising bonding a Ag-plated electronic component, a bare Cu frame electronic component, or a Ni-plated electronic component using the Bi-based solder alloy of any one of the first to eighth aspects.

A tenth aspect of the present invention provides an electronic component-mounted board produced by mounting an electronic component using the Bi-based solder alloy of any one of the first to eighth aspects at a reflow work peak temperature of 260 to 265°C.

### Advantageous Effects of the Invention

The Bi-based solder alloy of the present invention is substantially free of Pb and has a solidus temperature of 265°C or more and a liquidus temperature of 390 °C or less. Fine particles including a Ag-Al intermetallic compound are dispersed in the solder alloy. Thus, there can be provided a Bi-based solder alloy that prevents an electronic component from being degraded or damaged by heat during bonding or prevents a remelting problem from being caused by heat during reflow and that has high joint reliability. This Bi-based solder alloy can be suitably used for die bonding, which is a process of making a joint inside an electronic component, or other purposes. Since this Bi-based solder alloy has improved mechanical strength and machinability, it can be formed into a preform wire solder, which then can be wound up. In particular, this Bi-based solder alloy is suitably used as a high-temperature solder alloy preform material for die bonding.

Further, addition of the above Ag and Al, as well as one or more of P and Ge to this Bi-based solder alloy as added components can improve the wettability of the solder, reduce the occurrence of voids during joining, and prevent a reduction in the strength of joining to a bare Cu frame.

Further, addition of the above Ag and Al, as well as one or more of Sn and Zn to the Bi-based solder alloy as added components allows the solder alloy to be applied to a Ni-plated lead frame island without reducing the wettability thereof and can prevent a reduction in j oint strength after joining an electronic component to the lead frame island.

Further, by using an electronic component using the Bi-based solder alloy of the present invention or a method for bonding an electronic compound to a board of the present invention, an electronic component-mounted board can be provided that does not cause changes in chip properties or the oxidation of the members and has high mechanical strength.

### Brief Description of the Drawings

Fig. 1 is a sectional view showing an example of a semiconductor package using a Bi-based solder alloy of the present invention.
Fig. 2 is a chart showing a measurement result of the melting point of a conventional Bi-based solder alloy (Bi/2.5Ag).
Fig. 3 is a chart showing a measurement result of a Bi-based solder alloy (Bi/3Ag/0.5Al), which is an example of the present invention.
Fig. 4 is a chart showing a measurement result of the melting point of a Bi-based solder alloy (Bi/5Ag/1Al/0.05Ge), which is an example of the present invention.
Fig. 5 is a chart showing a measurement result of the melting point of a Bi-based solder alloy (Bi/5Ag/1Al/0.3Sn), which is an example of the present invention.
Fig. 6 is a chart showing a tensile test result of a conventional Bi-based solder alloy (Bi/2.5Ag).
Fig. 7 is a chart showing a tensile test result of a Bi-based solder alloy (Bi/3Ag/0.5Al), which is an example of the present invention.
Fig. 8 is a chart showing a tensile test result of a Bi-based solder alloy (Bi/5Ag/1Al/0.05Ge), which is an example of the present invention.
Fig. 9 is a chart showing a tensile test result of a Bi-based solder alloy (Bi/5Ag/1Al/0.3Sn), which is an example of the present invention.

### Description of Embodiments

The present invention relates to a Bi-based solder alloy including a specific amount of Al in Bi-Ag and having particles including a Ag-Al intermetallic compound dispersed therein, a method of bonding a Ag-plated electronic component, a bare Cu frame electronic component, an Ni-plated electronic component, or the like using the same, and an electronic component-mounted board.

### 1. Components and Compostion of Bi-Based Solder Alloy (1) Bi-Ag

The Bi-based solder alloy of the present invention contains, as a main component, Bi, which is an element belonging to Group VA of the periodic table and is a very brittle metal having a less symmetric trigonal crystal (rhombohedral crystal) structure.

As described above, conventional Bi-Ag solders are known as high-temperature solders which do not contain lead and have higher solidus temperatures than 260°C, which is the upper limit of the reflow temperature when mounting an electronic component on a board. For example, a Bi-2.5mass%Ag solder is a eutectic alloy and has a solidus temperature of 262°C, which is lower than the melting point of pure Bi, 271°C, by about 9°C.

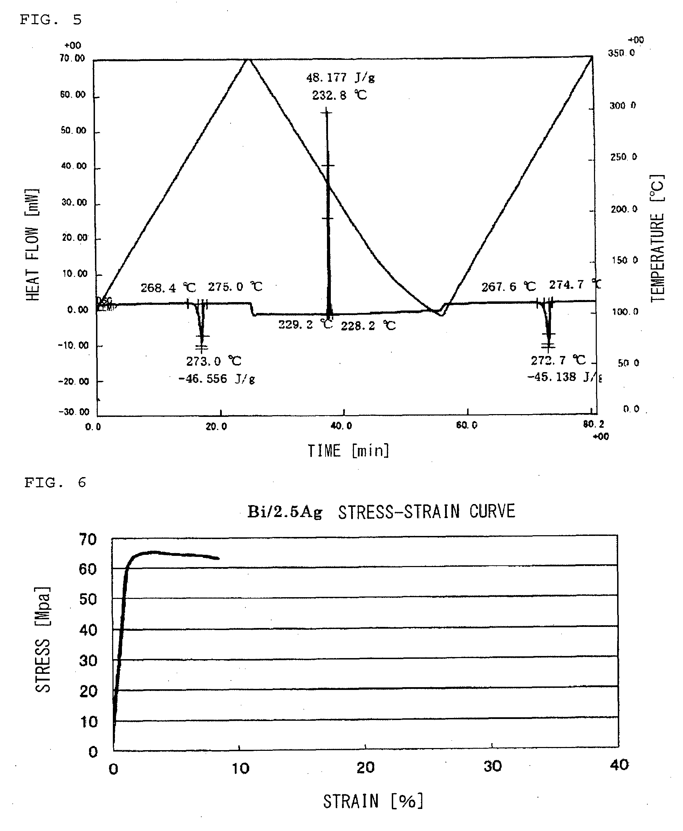

In the case of conventional Bi-Ag solders, even a Bi/2.5Ag eutectic solder alloy, as shown in Fig. 6, only exhibits an elongation of 8% or so. Due to such brittleness, conventional Bi-Ag solders are more likely to cause a problem during joining or in a subsequent reliability test. Further, they have failed to obtain machinability into a preform solder or the possibility of continuous supply by a device.

For these reasons, to raise the solidus temperature of a Bi-Ag solder, the present inventor paid attention to Al, which is an element that, when combined with Bi, lowers the melting point to a lesser extent or does not lower it compared to a Bi-Ag eutectic. As a result, by adding Al at a specific ratio to Ag, the present inventor could obtain a solder having a high solidus temperature and an appropriate liquidus temperature, as well as having improved mechanical strength, machinability, and the like.

That is, the present inventor could obtain a solidus temperature of 265°C or more by setting the ratio between Ag and Al to a specific range while using a Bi-Ag solder as a base. Further, the Bi-based solder alloy of the present invention can maintain the initial state thereof in an electronic component without remelting even after the electronic component is mounted on a board, as well as is excellent in mechanical strength, machinability, and the like.

Hereafter, the components of the Bi-based solder alloy of the present invention, a method of bonding an electronic component using the solder alloy, an obtained electronic component-mounted board, and the like will be described in detail.

While, in the present invention, the content of Bi is determined in accordance with the contents of Ag, Al, and the like, which are other essential added components, it must be 80 mass% or more with respect to the total mass of the solder alloy. If the content of Bi is less than 80 mass%, the liquidus may be significantly raised, and adverse effects, such as changes in chip properties and the promotion of oxidation of the members , may occur.

In the solder alloy of the present invention, Ag forms a Ag-Al intermetallic compound (to be discussed later) with Al, and the particles thereof are dispersed in Bi. Thus, the brittleness of the Bi matrix is dispersed/strengthened and improved.

The content of Ag is set to 0.6 to 18 mass%. If the content of Ag is less than 0.6 mass%, a sufficient amount of Ag-Al compound would not be formed; the brittle mechanical properties of the Bi matrix would become dominant; the elongation would not be sufficiently improved; and joint reliability, solder machinability, or the possibility of continuous supply by a device could not be obtained.

If the content of Ag is more than 18 mass%, the solder would exhibit poor wettability, thereby losing joint reliability. In the present invention, the content of Ag is preferably 1 to 15 mass%.

### (2) Al

In the Bi-based solder alloy of the present invention, Al raises the solidus temperature of the Bi-Ag solder, as well as improves the brittle mechanical properties specific to Bi-based solders.

The content of Al is 0.1 to 3 mass%. If the content of Al is less than 0.1 mass%, the Bi-Ag solidus temperature may not be sufficiently raised, that is, may not be raised to 265°C or more. Consequently, the solder may be remelted, which may impair joint reliability. On the other hand, if the Al content is more than 3 mass%, the liquidus temperature would be raised, and the solder would fail to wet at joining working temperatures of 400°C or less.

The Al amount is determined in accordance with the Ag content. Specifically, the Al amount is set to 1/20 to 1/2 of the Ag content. The reason is that an Ag₂Al intermetallic compound of an intermediate layer ζ phase and an Ag₃Al intermetallic compound of an intermediate layer µ phase are present at a 5 to 33wt% Al proportion in a Ag-Al phase diagram. If the Al-Ag ratio does not fall within the above range, the wettability of the solder becomes poor, thereby losing joint reliability. The Al content is .preferably 1/15 to 1/4 of the Ag content.

In the Bi-Ag-Al based solder alloy of the present invention, a Ag-Al intermetallic compound is present in the solder alloy in the form of particles. Since the Ag-Al intermetallic compound particles are dispersed in Bi, the brittleness of the Bi matrix can be dispersed/strengthen and improved. As used herein, the term "Ag-Al intermetallic compound" refers to an intermetallic compound containing Ag and Al and includes Ag-Al compounds in which the amount of one of the Ag metal and Al metal is extremely small and Ag-Al compounds containing Te, Ni, Cu, Sn, Zn, P, Ge, or the like (to be discussed later).

The diameters of the particles including the Ag-Al intermetallic compound are preferably smaller than 50 µm. Further, particles having diameters of less than 50 µm with respect to the total volume of the particles are preferably 97 volume% or more, more preferably 98 volume% or more, even more preferably 99 volume% or more. If particles having diameters of 50 µm or more are 3 volume% or more, the dispersion/strengthening of the compound may fail locally. Thus, the brittleness of the Bi matrix may remain, and the Bi matrix may be broken from the brittle portion. As a result, the brittleness as a whole may not be improved. This would result in poor joint reliability or poor handleability. The diameters of the particles including the Ag-Al intermetallic compound are more preferably less than 40 µm, particularly preferably less than 30 µm.

The sizes and distribution state of the precipitate particles including the Ag-Al intermetallic compound can be easily determined by light microscopy. In the measurement of the particle diameters , specimens are observed using a 200x light microscope, and the number of all particles including the intermetallic compound in the field of view is counted. Further, by measuring the cross-sectional diameters of the particles and multiplying the measured values by 1.12, the particle diameters are obtained. On the basis of these particles diameters and assuming that all the intermetallic compound particles are spherical particles, the volume of each intermetallic compound particle is calculated. The percentage of particles having diameters of 50 µm or less of all the particles is calculated in volume%.

### (3) Te, Ni, Cu

The Bi-based solder alloy of the present invention may contain one or more selected from Te, Ni, and Cu as optional added components. Since Te, Ni, and Cu are elements which precipitate at higher temperatures than the liquidus temperature of a Bi-Ag-Al alloy, these elements are primary crystal components that initially precipitate in the solder alloy. Accordingly, these elements have the effect of finely precipitating the crystal grains (particles) of an Ag-Al intermetallic compoundormatrixwhichis to precipitate later.

As a result, coarsening of the solder alloy solidification structure is suppressed as a whole. The solder structure becomes a finer solidification structure than that when Te, Ni, or Cu is not added, and is less likely to cause cracks.

The content of Te, Ni, or Cu is preferably 0.01 to 1 mass%, more preferably 0.05 to 0.8 mass%. The reason is that if the content of Te, Ni, or Cu is more than 1 mass%, that element may be produced as a coarse primary crystal component; if the amount is less than 0.01 mass%, that element would not sufficiently contribute to fining the solidification structure.

The solder alloy of the present invention is preferably used for Ag-plated electronic components. It is substantially free of Pb and contains Bi, Ag, and Al as essential added components. It may contain one of Te, Ni, and Cu as an optional added component. As used herein, the term "substantially" means that the solder alloy may contain Pb as an inevitable impurity. In addition to Pb, the solder alloy may contain inevitable impurities, such as Sb and Te, to the extent that the properties of the solder alloy of the present invention are not affected.

The sum of inevitable impurities, if any, is preferably less than 100 ppm considering the influence on solidus temperature, wettability, or joint reliability.

### (4) P, Ge

A Bi-based solder alloy of the present invention for bare Cu electronic components contains the above Bi, Ag, and Al, as well as one or more of P and Ge as added elements. P or Ge is added to improve the wettability of the solder and to reduce the occurrence of voids during joining. The added P or Ge preferentially oxidizes and thus the oxidation of the solder surface is suppressed. As a result, it is possible to improve the wettability of the solder and to reduce the occurrence of voids during joining.

The content of P or Ge is 0.001 to 0.3 mass%. Addition of P or Ge more than 0.3 mass% would form many oxides and thus affect the wettability; addition of P or Ge less than 0.001 mass% would make addition effects insufficient. The content of P or Ge is preferably 0.003 to 0.1 mass%, more preferably 0.005 to 0.05 mass%.

The Bi-based solder alloy of the present invention for bare Cu electronic components preferably further contains Cu described in (3) as an optional component. Cu has the effect of promoting the reaction between the solder alloy and the bare Cu frame and improving the wetting spread of the solder alloy.

Of the elements of the solder to be dispersed into the bare Cu frame, Al often preferentially moves and reacts. However, if the solder contains Cu, the Cu atoms disperse and move between the solder and the bare Cu frame surface and thus produce the effect of improving the wetting spread of the solder alloy.

Further, Cu is an element that precipitates at a higher temperature than the liquidus temperature of a Bi-Ag-Al alloy. Accordingly, as a primary crystal component which initially precipitates, Cuhas the effect of finely precipitating the crystal grains of a Ag-Al compound or matrix which is to precipitate later. Thus, coarsening of the solidification structure can be suppressed as a whole. As a result, the solder solidification structure become finer than that not containing Cu and is less likely to cause cracks.

The content of Cu is 0 to 1 mass%. Cu added in more than 1 mass% may be produced as a coarse primary crystal component; Cu added in less than 0.01 mass% may not sufficiently contribute to fining the solidification structure. Accordingly, the content of Cu is more preferably 0.01 to 1 mass%, even more preferably 0.03 to 0.8 mass%.

### (5) Sn, Zn

A Bi-based solder alloy of the present invention for Ni-plated electronic components contains the above Bi, Ag, and Al elements, as well as contains one or more of Sn and Zn as added elements in order to improve the wettability of the solder and to increase the joint strength after joining. Sn or Zn moves on the joint interface earlier than the Bi, Ag, and Al elements and forms a reaction layer with the substance of the joint interface, such as Ni. Thus, it seems to be possible to improve the wettability of the solder and to increase the joint strength after joining.

The content of Sn or Zn is 0.01 to 3 mass%, preferably 0.05 to 2.0 mass%, more preferably 0.1 to 1.5 mass%. Addition of Sn more than 3 mass% would leave many Bi-Sn low-melting-point layers in the solder and produce a low-melting-point abnormality when using the solder; addition of Zn more than 3 mass% would produce a thick oxide film layer and thus affect the wettability. Addition of Sn or Zn less than 0.01 mass% would undesirably make the wettability over the plated Ni, which is an addition effect, insufficient.

The Bi-based solder alloy of the present invention for Ni-plated electronic components preferably contains the above elements, as well as Cu described in (3) as an optional element. Cu has the effect of promoting the reaction between the solder and the plated Ni and improving the wetting spread of the solder.

Of the elements of the solder to be dispersed in the plated Ni, Al often preferentially moves and reacts. However, if the solder contains Cu, the Cu and Ni atoms disperse and move between the solder and the surface of the plated Ni, thereby producing the effect of improving the wetting spread of the solder.

Further, Cu is an element that precipitates at a higher temperature than the liquidus temperature of a Bi-Ag-Al alloy. Accordingly, as a primary crystal component which initially precipitates, Cuhas the effect of finely precipitating the crystal grains of a Ag-Al compound or matrix which is to precipitate later. Thus, coarsening of the solidification structure can be suppressed as a whole. As a result, the solder solidification structure becomes finer than that not containing Cu and is less likely to cause cracks.

The content of Cu is 0 to 1 mass%. Cu added in more than 1 mass% may be produced as a coarse primary crystal component and thus reduce the wettability of the melted solder; Cu added in less than 0.01 mass% may not sufficiently contribute to fining the solidification structure. Accordingly, the content of Cu is more preferably 0.01 to 1 mass%, even more preferably 0. 03 to 0.8 mass%.

The solder alloy of the present invention for Ni-plated electronic components is substantially free of Pb and contains Bi, Ag, and Al as main components and Sn or Zn as an essential added component. The solder alloy of the present invention for Ni-plated electronic components may further contain one or more selected from P and Ge as an optional added element.

The content of P or Ge is 0.001 to 0.3 mass%, preferably 0.01 to 0.1 mass%. Addition of P or Ge more than 0.3 mass% would form many oxides and thus affect the wettability: addition of P or Ge less than 0.001 mass% would make the addition effect insufficient. The content of P or Ge is preferably 0.003 to 0.1 mass%, more preferably 0.005 to 0.05 mass%.

### 2. Production of Bi-based Solder Alloy

The Bi-based solder alloy of the present invention may be produced using any method. The Bi-based solder alloy f or Ag-plated electronic components may be produced using any conventional known method as long as it will contain the above Bi, Ag, and Al as essential components; the Bi-based solder alloy for bare Cu electronic components may be produced using any conventional known method as long as it will additionally contain P or Ge; the Bi-based solder alloy for Ni-plated electronic components may be produced using any conventional known method as long as it will contain Bi, Ag, and Al as essential components and Sn or Zn as an additional component.

To form particles having diameters of 50 µm or less (Ag-Al intermetallic compound) in an solder alloy, it is preferred to use, as raw materials, shot materials or individual finished articles having small diameters of 5 mm or less, particularly 3 mm or less.

These raw materials are charged into a melting furnace, placed in a nitrogen or inert gas atmosphere to suppress the oxidation of the raw materials, and heated and melted at 500 to 600°C, preferably at 500 to 550°C. To mold molten metal having a melting temperature of 500°C or more, there may be used, for example, a cylindrical graphite mold having an inner diameter of 30 mm or less and a thickness of about 10 mm. When the metal starts to melt, it is sufficiently stirred so as to prevent the composition thereof from varying locally. Although the stirring time depends on the device, the amount of raw materials, or the like, it is preferably set to 1 to 5 minutes.

Then, a material having high conductivity, for example, a chill formed of Cu, preferably a hollow chill through which cooling water is passed is closely attached to the outside of the mold, and the molten metal is poured into the mold. Then, the molten metal is cooled and solidified to about 260°C at a cooling speed of 3°C/sec or more, more preferably 20°C/sec or more, although the cooling speed depends on the composition. Byusing this method, it is possible to reliably and stably produce a solder material ingot whose most precipitate particles have diameters of less than 50 µm.

If continuous casting is used considering productivity, it is preferred to continuously cast the molten metal into an ingot whose shape has a small cross-sectional area. For example, it is preferred to use a die having an inner diameter of 30 mm or less, to cover the die with a water-cooling jacket for cooling and solidifying the molten metal quickly, and to cool the molten metal at a cooling temperature of 50°C/sec or more.

The Bi-based solder alloy of the present invention thus obtained is substantially free of Pb and has a solidus temperature of 265°C or more and a liquidus temperature of 390°C or less. This Bi-based solder alloy can maintain the initial shape in an electronic component without remelting even after mounting the electronic component on a board.

The solidus temperature is measured using a differential scanning calorimeter (DSC) and is 265°C or more, preferably 267°C or more, more preferably 268°C or more. The liquidus temperature is identified using differential scanning calorimetry (DSC) and a melting test and is 390°C or less, preferably 380°C or less, more preferably 360 to 380°C.

The Bi-based solder alloy of the present invention is excellent in mechanical strength, machinability, and joint reliability.

The elongation of the Bi-based solder alloy of the present invention is preferably 15 to 50%, more preferably 20 to 45%. The elongation and tensile strength are obtained, for example, by extruding the Bi-based solder alloy into a 0. 75-mm ϕ preform wire solder and then measuring the wire solder using a tensile tester (Tensilon universal tester).

### 3. Method for Bonding Electronic Component

The Bi-based solder alloy of the present invention is used in a method for bonding a Ag-plated electronic component, a bare Cu frame electronic component, a Ni-plated electronic component, or the like. Thus, an electronic component-mounted board can be easily produced.

### (1) Bonding to Ag-Plated Electronic Component

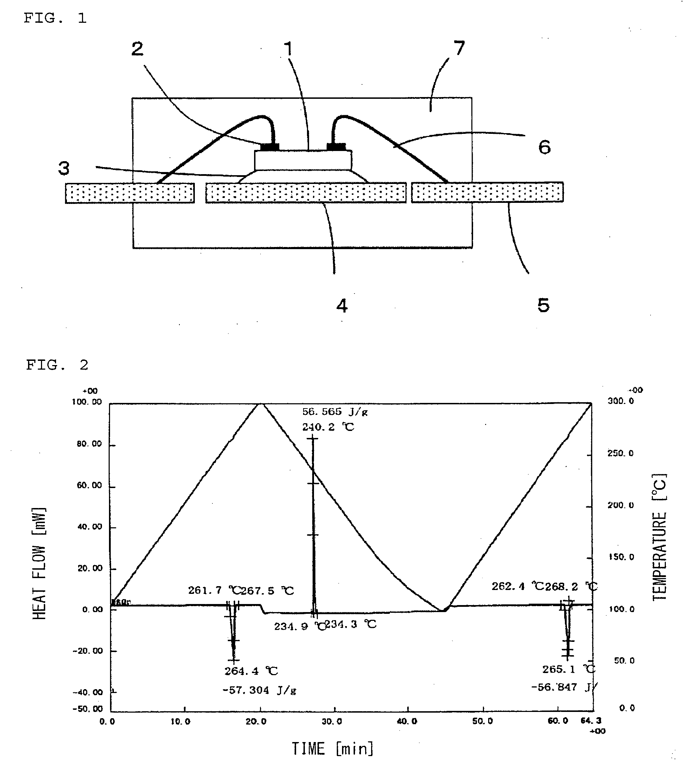

Fig. 1 shows a sectional view of a semiconductor package of an electrode component using the Bi-based solder alloy of the present invention. This semiconductor package is produced by coating the center of a lead frame island 4 with a Bi-based solder alloy 3 of the present invention, placing a semiconductor chip 1 on the solder alloy 3 so that the semiconductor chip 1 is soldered (die-bonded), then connecting electrodes 2 on the semiconductor chip 1 to lead frames 5 through bonding wires 6, and covering all these components with a mold resin 7 except for the perimeters of the lead frames 5.

The lead frame island 4 coated with the solder alloy 3 of the present invention is previously Ag-plated, and fine particles including a Ag-Al intermetallic compound are dispersed in the solder alloy. Thus, the electronic component is not degraded or damaged due to heat during bonding, nor does a remelting problem occur due to heat during reflow soldering.

### (2) Bonding to Bare Cu Frame Electronic Component

If the lead frame island 4 is a bare Cu frame, which is not subjected to a treatment such as Ag plating or Ni plating, it is important that the solder wet and spread over the bare Cu frame. However, when the lead frame island 4 is coated with the solder alloy 3 and Cu starts to preferentially react with a particular element in the solder, for example, Ag, an oxide film on the bare Cu frame tends to reduce the wetting spread of the solder. Further, Cu is hardly dissolved in Bi or Pb and therefore the solder tends to wet and spread over the bare Cu frame poorly compared to over a Ag-plated lead frame island. That is, the surface of a bare Cu frame tends to oxidize and is rough and therefore the solder tends to wet and spread thereover poorly.

On the other hand, the solder alloy of the present invention for bare Cu frame electronic components contains P or Ge and thus a reduction in the wettability thereof is suppressed. That is, Ag produces a metal reaction with Al while forming an intermetallic compound with Al and further forms a eutectic with melted Bi, and thus melts into the solder. At this time, P or Ge in the solder alloy fines the structure of the intermetallic compound, as well as improves the wetting spread over the bare Cu frame. Further, P or Ge preferentially oxidizes and thus the oxidation of the solder surface is suppressed. As a result, the wettability of the solder is improved, and the occurrence of voids during joining is reduced.

That is, according to the method for bonding an electronic component of the present invention, it is possible to bond an electronic component to a mounting board of a bare Cu frame having no Ag layer or Ni layer plated thereon using the Bi-based solder alloy.

When mounting the soldered (die-bonded) semiconductor chip 1 on the board, it is heated to around 260°C, which is the reflow temperature. However, the solidus temperature of the Bi-based solder alloy of the present invention is 265 °C or more and therefore the electronic component can maintain the mechanical strength without suffering a variation in chip properties or the oxidation of the members.

### (3) Bonding to Ni-plated Electronic Component

Typically, the lead frame island 4 in Fig. 1 is Ag-plated. On the other hand, the lead frame island 4 may be subjected to Ni plating serving as plating which can control the reactivity with a solder, rather than being Ag-plated. Ni plating is often used for car-mounted devices.

While Ni preferentially reacts with Sn or Zn in the solder, the reaction speed thereof is lower than those of Ag and Cu. Further, Ni is hardly dissolved in Bi or Pb. For these reasons, a solder tends to wet and spread over plated Ni more poorly than over a bare Cu frame. However, plated Ni suppresses the growth of a joint interface reaction layer in a temperature cycle test or the like in a reliability test and thus is believed to have long-term reliability. Note that when performing Ni plating, an appropriate condition must be set due to the poor wetting spread of a solder over plated Ni.

That is, when the solder alloy 3 is applied to the Ni-plated lead frame island 4, it wets and spreads thereover poorly compared to over plated Ag or bare Cu. Thus, a joint failure occurs, resulting in a reduction in joint strength.

On the other hand, the solder alloy of the present invention containing Sn or Zn suppresses a reduction in joint strength caused by a reduction in wettability. As described above, Ag produces a metal reaction with Al while forming an intermetallic compound with Al and further forms a eutectic with melted Bi, and thus melts into the solder. At this time, the solder and Ni lead frame are joined together with sufficient strength owing to Sn or Zn in the solder alloy.

The reason is that while plated Ni hardly produces an alloy reaction with Bi, as described above, Sn or Zn in the solder starts to preferentially react with Ni. Thus, the joint ability of the entire joint is maintained. If the joint strength is insufficient, cracks would occur and develop in anunj oinedportion or its vicinity due to the concentration of stress in a reliability test, such as a temperature cycle test, failing to obtain joint reliability. On the other hand, the solder alloy of the present invention and platedNi can be joined together with sufficient joint reliability.

That is, according to the method for bonding an electronic component of the present invention, it is possible to bond an electronic component to a mounting board having a Ni plating layer formed on an copper material, using the Bi-based solder alloy.

When mounting the soldered (die-bonded) semiconductor chip 1 on the board, it is heated to around 260°C, which is the reflow temperature. However, the solidus temperature of the Bi-based solder alloy of the present invention is 265°C or more and thus the electronic component can maintain the mechanical strength without suffering a variation in chip properties or the oxidation of the members.

### 4. Electronic Component-Mounted Board

An electronic component-mounted board of the present invention is produced by mounting an electronic component using any one of the various types of Bi-based solder alloys at a reflow work peak temperature of 260 to 265°C.

A board on which an electronic component is to be mounted may be a conventional known board and is typically a ceramic board. A printed board or Si board may be used.

### Examples

The present invention will be described in more detail using Examples. However, the present invention is not limited to the Examples. The following measurement and evaluation methods were used in the Examples.

### (1) Solidus Temperature and Liquidus Temperature

The solidus temperature and liquidus temperature were measured using a differential scanning calorimeter (DSC).

### (2) Tensile Strength and Elongation

First, Bi alloys having component compositions shown in Table 1 were melted using a method described below and an atmospheric melting furnace and extruded into 0.75-mm ϕ preform wire solder samples.

The obtained 0.75-mm ϕ wire solders were each cut into a predetermined length and used as a test sample for measuring tensile strength. Each test sample was set in a tensile tester (device name: Tensilon universal tester), and the tensile strength and elongation thereof were measured automatically.

### (3) Observation and Particle Diameter of Ag-Al Intermetallic Compound

First, Bi alloys having component compositions shown in Table 1 were melted using an atmospheric melting furnace and extruded into 0.75-mm ϕ preform wire solder samples.

The obtained 0.75-mm ϕ wires were each embedded in a resin and cross-sectionally polished. Each wire was immersed in an aqueous solution of nitric acid (nitric acid concentration 20%) having room temperature for five seconds and etched to provide a test sample for cross-sectionally observing the alloy structure.

While, in each test sample, the parent phase of Bi serving as a main element looked black due to corrosion, precipitate particles such as an intermetallic compound looked white and shiny. Thus, the sizes or distribution state of the precipitate particles could be easily determined by light microscopy. Each test sample was observed using a 200x light microscope, and the number of all particles including an intermetallic compound in the field of view was counted. Further, the cross-sectional diameters of the particles were measured, and values obtained by multiplying the measured values by 1.12 were used as the particle diameters. On the basis of these particle diameters and assuming that all the intermetallic compound particles are spherical particles, the volume of each intermetallic compound particle was calculated, and the percentage of particles having diameters of less than 50 µm of all the particles was calculated in volume%.

### (4) Wettability

A die bonder (CPS-400 available from NEC Machinery Corp.) was set in a nitrogen atmosphere; the temperature was set to 390°C; each 0.75-mm ϕ sample obtained in the above (2) was set in the die bonder and provided to a lead frame; then, a dummy chip was produced by evaporating Au on the die bonding surface of a silicon chip; and the dummy chip was die-bonded to the lead frame.

The wettability of each solder was evaluated as follows: a solder which did not extend off the chip edge was evaluated as "poor"; a solder which extended off as "good"; and a solder which extended off the chip edge more uniformly as "excellent."

### (5) Joint Reliability

Further, a sample obtained by die-bonding the dummy chip to the lead frame was molded using an epoxy resin. Using the molded product, first, a reflow test was conducted at 260°C and then 500 cycles (or 700 cycles) of a temperature cycle test at -50°C/150°C were conducted. Then, the resin was opened, and the die-bonded joint was observed.

The joint reliability was evaluated as follows: a case in which no crack occurred in the chip or joint was evaluated as "good" and the number of cycles was shown; and a case in which a joint failure or crack occurred as "poor."

### Examples 1 to 11

### (1) Production of Solder Alloys (Preform Solders) for Ag-plated electronic components

First, Bi, Ag, Al, Te, Cu, and Ni (the purity of each element: 99.99 weight% or more) in the form of 3-mm ϕ or less shots were provided as raw materials. If any raw material was a large flake or bulk, the size thereof was reduced to 3 mm or less by cutting, crushing, or other means so that, in the melted alloy, the composition did not vary among sampling areas but rather was uniform. Then, a predetermined amount of these raw materials was charged into a graphite crucible for a high-frequency melting furnace.

Then, the crucible containing the raw materials was put into the high-frequency meltingfurnace,and nitrogen waspassed through the melting furnace at a flow rate of 0.7L/min or more per kg of the rawmaterials to suppress oxidation. In this state, the inside of the melting furnace was heated to 500°C at a temperature rise speed of 5°C/sec so as to heat and melt the raw materials. When the metals start to melt, the metals were sufficiently stirred with a stirring bar for three minutes so that the composition did not vary locally. After confirming that the metals were sufficiently melted, the high-frequency melting furnace was turned off, and the crucible was taken out shortly. Then, the molten metal in the crucible was poured into a mold for a solder master alloy.

Used as the mold was a cylindrical graphite mold having an inner diameter of 30 mm or less and a thickness of about 10 mm. A material having good heat conductivity (a hollow copper chill through which cooling water was passed) was closely attached to the outside of the mold. After pouring the molten metal into the mold, the molten metal was quickly cooled and solidified to about 260°C at a cooling temperature of 5°C/sec, although the cooling temperature depended on the composition.

Note that in Example 4 , a continuous casting machine provided with a water-cooling jacket around a die was used, and after heating and melting the raw materials, the melt was cooled at a cooling speed of about 60°C/sec.

Using part of the obtained solidified product as a sample, the amount of particles (Ag-Al intermetallic compound) having diameters of less than 50 µm formed in the solder alloy was measured using the above method.

Then, the remainder of the solidified product was transferred to an atmospheric melting furnace and extruded into a preform wire solder having a diameter of 0.75 mm on conditions below. Note that in all these Examples, the solder alloy could be formed into a wire solder, which then could be would up.

### (2) Physical Properties and Performance Test

Using the preform wire solder samples obtained using the above method, the solidus temperature and liquidus temperature were measured. Also, the diameters of particles including a Ag-Al intermetallic compound were observed and measured.

Then, each preform solder sample was die-bonded to a Ag-plated lead frame, and the wettability was evaluated. Further, these members were molded using an epoxy resin and then a temperature cycle test and a reflow test were conducted to evaluate the joint reliability. The results are shown in Table 1.

### Comparative Examples 1 to 4

Solder alloys were produced as in Example 1 except that raw materials were mixed so that compositions shown in Table 1 were obtained. Using part of each obtained solidified product as a sample, the amount of particles (Ag-Al intermetallic compound) having diameters of less than 50 µm formed in the solder alloy was measured using the above method. Further, apreformwiresolder was formed from each solder alloy. In all these Comparative Examples, the solder alloy could be formed into a wire solder, which then could be would up.

Using the obtained preform wire solder samples, the solidus temperature and liquidus temperature were measured. Also, the diameters of particles including a Ag-Al intermetallic compound were observed and measured.

Then, each preform solder sample was die-bonded to a Ag-plated lead frame, and the wettability was evaluated. Further, these members were molded using an epoxy resin and then a temperature cycle test and a reflow test were conducted to evaluate the joint reliability. The results are shown in Table 1.

**[Table 1]**

| | Composition (mass%) | | | | | | Melting point (solid phase) | Melting point (liquid phase) | Elon -gation | Less than 50*µ*m particle percentage(%) | Wettability (Ag plating) | Joint reliability |
|---|---|---|---|---|---|---|---|---|---|---|---|---|
| | Bi | Ag | Al | Te | Ni | Cu | | | | | | |
| Example1 | Balance | 0.6 | 0.1 | - | - | - | 269°C | 269°C | 16% | 99.7% | GOOD | 500 cycles |
| Example2 | Balance | 1 | 0.5 | - | - | - | 269°C | 269°C | 25% | 99.1% | GOOD | 500 cycles |
| Example3 | Balance | 3 | 0.5 | - | - | - | 269°C | 269°C | 36% | 99.4% | GOOD | 500 cycles |
| Example4 | Balance | 5 | 1 | - | - | - | 269°C | 300°C | 39% | 98.8% | GOOD | 500 cycles |
| Example5 | Balance | 15 | 1 | - | - | - | 265°C | 360°C | 30% | 98.2% | GOOD | 500 cycles |
| Example6 | Balance | 15 | 3 | - | - | - | 269°C | 380°C | 32% | 97.5% | GOOD | 500 cycles |
| Example7 | Balance | 18 | 2 | - | - | - | 267°C | 380°C | 30% | 97.2% | GOOD | 500 cycles |
| Example8 | Balance | 3 | 0.5 | 0.1 | - | - | 269°C | 269°C | 36% | 99.7% | GOOD | 700 cycles |
| Example9 | Balance | 3 | 0.5 | - | 0.1 | - | 269°C | 269°C | 37% | 99.6% | GOOD | 700 cycles |
| Example10 | Balance | 3 | 0.5 | - | - | 0.1 | 269°C | 269°C | 37% | 99.6% | GOOD | 700 cycles |
| Example11 | Balance | 15 | 3 | - | 0.5 | 0.5 | 269°C | 380°C | 34% | 98.3% | GOOD | 700 cycles |
| Comparative Example1 | Balance | 3 | 4 | - | - | - | 269°C | 450°C | 38% | 96.1% | POOR | Less than 500 cycles (joint failure) |
| Comparative Example2 | Balance | 20 | 1 | - | - | - | 262°C | 400°C | 18% | 94.8% | POOR | Less than 500 cycles (joint failure) |
| Comparative Example3 | Balance | 2.5 | - | - | - | - | 262°C | 262°C | 8% | 99.6% | GOOD | Less than 500 cycles (crack) |
| Comparative Example4 | Balance | 2.5 | 0. 1 | - | - | - | 262°C | 262°C | 12% | 99.6% | GOOD | Less than 500 cycles (crack) |

### Evaluation

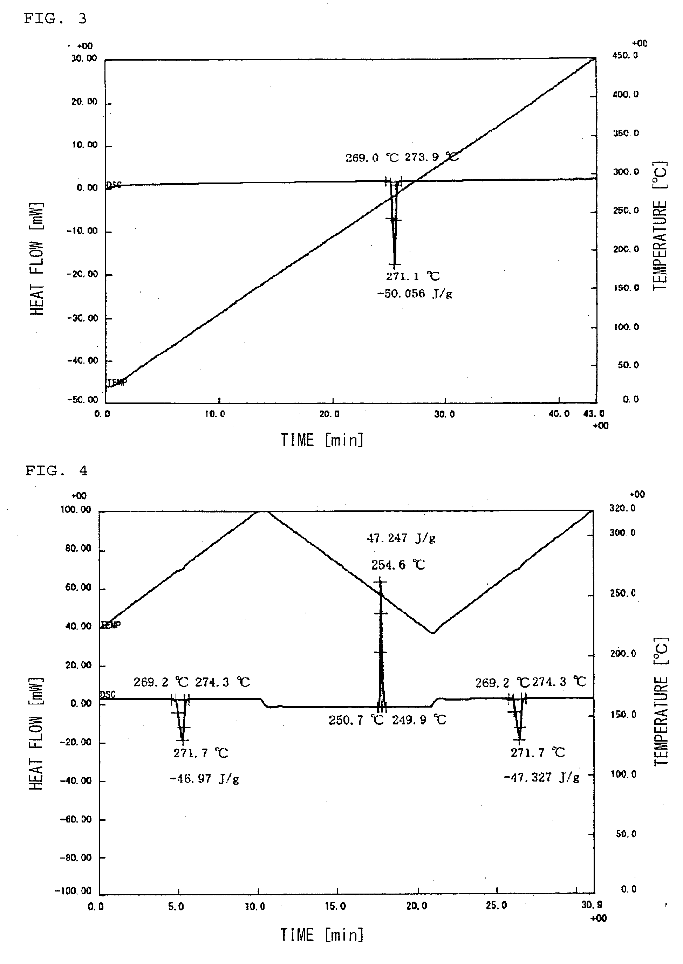

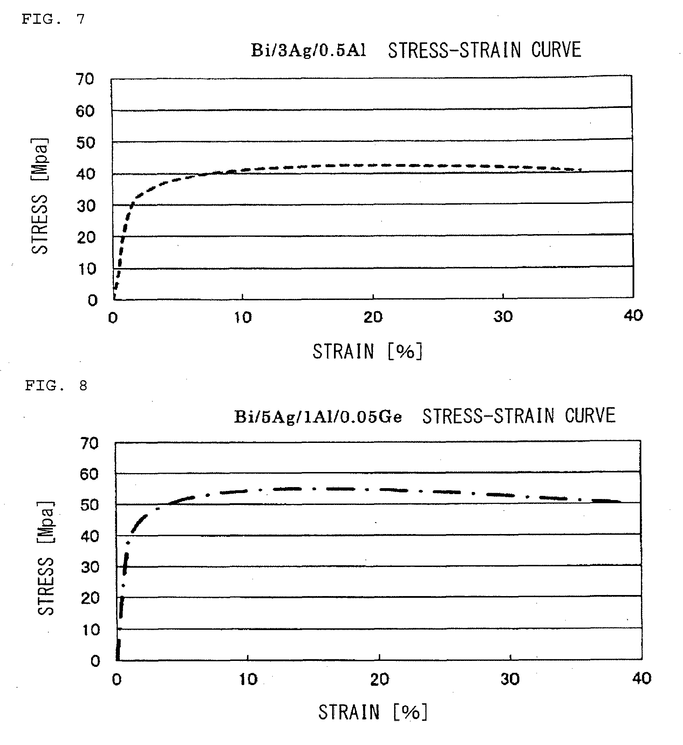

In Examples 1 to 7, the content of Al was 0.1 to 3 mass%, and the content ratio (X) of Al to Ag was in a range of 1/20≤X≤1/2. As typified by Example 3 shown in Fig. 3, these Examples were conf irmed to have solidus temperatures of 265°C or more. Examples 1 to 5, as typified by Example 3 shown in Fig. 7, were confirmed to have elongations of 15% or more and to have improved brittleness. Examples 2 to 5, which contained 0.5 mass% or more of Al, had elongations of more than 30% and therefore can be said to be very excellent in joint reliability, solder machinability, and the possibility of continuous supply by a device.

For Examples 1 to 7, by cross-sectional observation, it was confirmed that 97% or more of the particles of the added materials and the particles of an intermetallic compound formed therefrom in the solder wire had diameters of less than 50 µm. Particularly for Example 4, the cooling speed was higher than those of the other Examples and thus most of the particles had diameters of around 20 µm and were finer than those of the other Examples. These Examples were evaluated as "good" for wettability, and were also evaluated as "good" for joint reliability since no crack occurred in the chip or joint even in temperature cycle tests (500 cycles) . Note that these Examples could be supplied by a die bonder continuously without any problem.

Further, for each of Examples 1 to 7, after mounting on a mounting board such as a printed board, a reflow test was conducted at 260°C for 10 seconds five times and then it was checked whether an abnormality was present in the chip or joint. In any Example, any abnormality was not found, nor was a conspicuous void identified. As a result, it was confirmed that the areas joined using the solder alloys of the present invention for Ag-plated electronic components were maintained without melting even when held at a reflow temperature of 260°C for 10 seconds five times or so.

Examples 8 to 10 contained the same amounts of Bi, Ag, and Al as those of Example 1, as well as contained one of Te, Ni, and Cu. Example 11 contained the same amounts of Bi, Ag, and Al as those of Example 6, as well as contained both Ni and Cu. For these Examples, it was confirmed that 97% or more of the particles of the added materials and the particles of an intermetallic compound formed therefrom in the solder wire had diameters of less than 50 µm. These Examples were evaluated as "good" for wettability, and were also evaluated "good" since no crack occurred in the chip or joint even in a temperature cycle test (700 cycles) and a reflow test. Note that these Examples could be supplied by a die bonder continuously without any problem.

Comparative Example 1, on the other hand, contained a larger amount of Al than required. This Comparative Example was evaluated as "poor" in a wettability test at 390°C, and was also evaluated as "poor" for joint reliability since a crack occurred in the chip or joint in a temperature cycle test. Comparative Example 2 also had a high Ag content and failed to achieve a solidus temperature more than 265°C since the content ratio (X) of Al to Ag fell outside a range of 1/20≤X≤1/2. For a Bi/2.5Ag eutectic solder alloy of Comparative Example 3, the solidus and liquidus were 262°C, which was below the melting point of Bi alone, 271°C, as shown by a phase diagram in Fig. 2. This Comparative Example was evaluated as "good" in a wettability test, but was evaluated as "poor" for joint reliability since it exhibited an elongation of as low as about 8% due to not containing of Al and had brittle properties. Comparative Example 4 was evaluated as "good" in a wettability test, but was evaluated as "poor" for joint reliability since it exhibited an elongation of as low as 12% due to a lower Al content thereof than required; and a crack occurred in the chip or joint in a temperature cycle test due to brittle properties thereof.

Thus, it can be said that any peel, void, or the like does not occur in an area joined using the solder alloy of the present invention for Ag-plated electronic components even during ref low, during which an electronic component is mounted on a board, and therefore any problem does not occur in the properties of the electronic component.

### Examples 12 to 24

### (1) Production of Solder Alloys (Preform Solders) for Bare Cu Electronic Components

Preform wire solders were produced as in the Examples 1 to 11 except that Bi, Ag, Al, P, Ge, and Cu (the purity of each element: 99.99 weight% or more) were used as raw materials. In all these Examples, the solder alloy could be formed into a wire solder, which then could be would up.

### (2) Physical Properties and Performance Test

Using the preform wire solder samples obtained using the above method, the solidus temperature and liquidus temperature were measured. Also, the diameters of particles including a Ag-Al intermetallic compound were observed and measured. Then, each preform solder sample was die-bonded to a Cu lead frame, and the wettability was evaluated. Further, these members were molded using an epoxy resin and then a temperature cycle test and a reflow test were conducted to evaluate the joint reliability. The results are shown in Table 2.

### Comparative Examples 5 to 16

Solder alloys were produced as in the Examples except that raw materials were mixed so that compositions shown in Table 2 were obtained. In all these Comparative Examples, the solder alloy could be formed into a wire solder, which then could be would up.

Using the obtained preform wire solder samples, the solidus temperature and liquidus temperature were measured. Also, the diameters of particles including a Ag-Al intermetallic compound were observed and measured. Then, each preform solder sample was die-bonded to a Cu lead frame, and the wettability was evaluated. Further, these members were molded using an epoxy resin and then a temperature cycle test and a reflow test were conducted to evaluate the joint reliability. The results are shown in Table 2.

**[Table 2]**

| | Composition (mass%) | | | | | | Melting point (°C) | | Less than 50 µm particle percentage (%) | Wettability (Cu surface) | Joint reliability |
|---|---|---|---|---|---|---|---|---|---|---|---|
| | Bi | Ag | Al | P | Ge | Cu | Solid phase | Liqid phase | | | |
| Example12 | Balance | 0.6 | 0.1 | - | 0.001 | - | 269 | 269 | 99.7 | GOOD | 500 cycles |
| Example13 | Balance | 1 | 0.5 | 0.001 | - | | 269 | 269 | 99.7 | GOOD | 500 cycles |
| Example14 | Balance | 5 | 1 | - | 0.05 | - | 269 | 300 | 98.9 | GOOD | 500 cycles |
| Example15 | Balance | 5 | 1 | 0.05 | - | - | 269 | 300 | 98.9 | GOOD | 500 cycles |
| Example16 | Balance | 15 | 1 | - | 0.1 | - | 265 | 360 | 98.3 | GOOD | 500 cycles |
| Example17 | Balance | 15 | 1 | 0.1 | - | - | 265 | 360 | 98.2 | GOOD | 500 cycles |
| Example18 | Balance | 15 | 3 | - | 0.3 | 0.5 | 269 | 380 | 97.3 | GOOD | 700 cyeles |
| Example19 | Balance | 18 | 1 | 0.3 | - | 0.5 | 265 | 380 | 97.6 | GOOD | 700 cycle |
| Example20 | Balance | 18 | 0.9 | 0.05 | - | - | 265 | 380 | 97.7 | GOOD | 500 cycles |
| Example21 | Balance | 15 | 3 | - | 0.3 | 0.01 | 269 | 380 | 97.8 | GOOD | 700 cycles |
| Example22 | Balance | 15 | 3 | - | 0.3 | 1 | 269 | 380 | 97.1 | GOOD | 700 cycles |
| Example23 | Balance | 15 | 3 | - | 0.3 | 1.5 | 269 | 380 | 96.8 | GOOD | 500 cycles |
| Example24 | Balance | 15 | 3 | - | 0.3 | 0.05 | 269 | 360 | 97.9 | GOOD | 500 cycles |
| Comparative Example5 | Balance | 5 | 1 | - | - | - | 269 | 300 | 98.8 | POOR | Less than 500 cycles (joint failure) |
| Comparative Example6 | Balance | 5 | 1 | - | 0.0005 | - | 269 | 300 | 98.8 | POOR | Lees than 500 cycles (joint failure) Less than 500 cycles (joint failure) |
| Comparative Example7 | Balance | 5 | 1 | 0.005 | - | - | 269 | 300 | 98.7 | POOR | |
| Comparative Example8 | Balance | 15 | 1 | - | 0.4 | - | 265 | 360 | 95.6 | POOR | Less than 500 cycles (joint failure) |
| Comparative Example9 | Balance | 15 | 1 | 0.4. | - | 1.5 | 265 | 360 | 94.2 | POOR | Less than 500 cycles (joint failure) |
| Comparative Example10 | Balance | 0.5 | 0.1 | - | 0.001 | - | 262 | 262 | 99.8 | GOOD | Less than 500 cycles (crack) |
| Comparative Example11 | Balance | 0.6 | 0.05 | - | 0.001 | - | 262 | 262 | 99.7 | GOOD | Less than 500 cycles (crack) |
| Comparative Example12 | Balance | 15 | 0.5 | - | 0.001 | - | 262 | 360 | 98.3 | GOOD | Less than 500 cycles (crack) |
| Comparative Example13 | Balance | 5 | 3 | 0.001 | - | - | 269 | 390 | 96.6 | POOR | Less than 500 cycles (joint failure) |
| Comparative Example14 | Balance | 0.5 | 0.1 | - | 0.001 | 0.05 | 262 | 262 | 99.6 | GOOD | Less than 500 cycles (crack) |
| Comparative Example15 | Balance | 5 | 3 | 0.001 | - | 0.05 | 269 | 390 | 96.5 | POOR | Less than 500 cycles (joint failure) |
| Comparative Example16 | Balance | 20 | 0.9 | - | 0.001 | - | 262 | 400 | 97.6 | POOR | Less than 500 cycles (joint failure) |

### Evaluation

In Examples 12 to 24, the content of Al was 0.1 to 3 mass%, and the content ratio (X) of Al to Ag was in a range of 1/20≤X≤1/2. These Examples were confirmed to have solidus temperatures of 265°C or more, as typified by Example 14 shown in Fig. 4. For Examples 12 to 22 and 24, by cross-sectional observation, it was confirmed that 97% or more of the particles of the added materials and the particles of an intermetallic compound formed therefrom in the solder wire had diameters of less than 50 µm. Examples 12 to 17 and 20 were confirmed to have elongations of 15% or more and to have improved brittleness, as typified by Example 14 shown in Fig. 8. These Examples were evaluated as "good" for joint reliability since no crack occurred in the chip or joint at 500 cycles, which is a smaller cycle number. A conceivable reason is that these Examples contained P or Ge and thus wet and spread surely and improved reliability.

Examples 18, 19, and 21, and 22 contained P or Ge, as well as Cu and thus wet and spread more surely. These Examples, which contained 0.01 to 1.0% of Cu, were evaluated as "good" for joint reliability since no crack occurred in the chip or joint even in a temperature cycle test of 700 cycles, which is a larger number of cycles.

Then, parts of samples obtained by molding these Examples were each mounted on a board at 260°C five times and then it was checked whether an abnormality existed in the chip or joint. As a result, in any case, any abnormality was not found, nor was a conspicuous void identified. Thus, it was confirmed that the areas joined using the solder alloys of the present invention for bare Cu electronic components were maintained without melting even when held at a reflow temperature of 260°C for 10 seconds five times or so.

Comparative Examples 5 to 9, which departed from the scope of the present invention, did not contain any of P and Ge, or contained one of those in an amount departing from the upper or lower limit of the required amount thereof. These Comparative Examples were evaluated as "poor" in wettability and reliability tests since they wet and spread over bare Cu frames poorly in wettability tests at 390°C. Note that the solidus and liquidus of a conventional Bi/2.5Ag eutectic solder alloy were 262°C, which was below the melting point of 271°C of Bi alone, as shown in a phase diagram in Fig. 2. This conventional solder alloy was evaluated as "good" in a wettability test, but was evaluated as "poor" for joint reliability since it exhibited an elongation of as low as about 8%, as shown in Fig. 6, due to not containing of Al and had brittle properties.

Comparative Examples 10 and 11 were evaluated as "good" for wettability since these Comparative Examples contained Ge within the scope of the present invention. However, these Comparative Examples were evaluated as unsatisfactory for 500 cycles since they contained Ag or Al departing from the scope of the present invention and a crack occurred in the solder layer in a reliability test.

Comparative Examples 12 to 13 contained Bi, Ag, and Al, and P or Ge within the scope of the present invention. Comparative Example 12 was evaluated as unsatisfactory for 500 cycles since the content ratio of Al to Ag was less than 1/20 and thus a crack occurred in the solder layer in a reliability test. Comparative Example 13 was evaluated as unsatisfactory for 500 cycles since the content ratio of Al to Ag was more than 1/2 and thus a wetting failure occurred in part of the joint due to the segregation of Al and a crack occurred in an poorly joined area.

Comparative Example 14 was obtained by adding Cu within the scope of the present invention to the solder alloy of Comparative Example 10, but was evaluated as unsatisfactory for 500 cycles since the crack in the solder layer was not improved. Comparative Example 15 was obtained by adding Cu within the scope of the present invention to the solder alloy of Comparative Example 13, but was evaluated as unsatisfactory for 500 cycles since the wetting failure was not improved. Comparative Example 16 had a liquidus temperature of 400°C, partially remained without melting at a joining temperature of 390°C, and wet and spread poorly, as well as had some unjoined surfaces. Accordingly, this Comparative Example was evaluated as unsatisfactory for 500 cycles.

Thus, it can be said that any peel, void, or the like does not occur in an area joined using the solder alloy of the present invention for bare Cu electronic components even during reflow, during which an electronic component is mounted on a board, and therefore any problem does not occur in the properties of the electronic component.

### Examples 25 to 37

### (1) Production of Solder Alloys (Preform Solders) for Ni-Plated Electronic Components

Preform wire solders were produced as in the Examples 1 to 11 except that Bi, Ag, Al, Sn, Zn, P, Ge, and Cu (the purity of each element: 99.99 weight% or more) were used as raw materials. In all these Examples, the solder alloy could be formed into a wire solder, which then could be would up.

### (2) Physical Properties and Performance Test

Using the preform wire solder samples obtained using the above method, the solidus temperature and liquidus temperature were measured. Also, the diameters of particles including a Ag-Al intermetallic compound were observed and measured.

Then, each preform solder sample was die-bonded to a Ni-plated lead frame, and the wettability was evaluated. Further, these members were molded using an epoxy resin and then a cycle test was conducted to evaluate the joint reliability. The results are shown in Table 3.

### Comparative Examples 17 to 30

Solder alloys were produced as in the Examples except that raw-material powders were mixed so that compositions shown in Table 4 were obtained. In all these Comparative Examples, the solder alloy could be formed into a wire solder, which then could be would up.

Then, using the obtained preform wire solder samples, the solidus temperature and liquidus temperature were measured. Also, the diameters of particles including a Ag-Al intermetallic compound were observed and measured.

Then, each preform solder sample was die-bonded to a lead frame, and the wettability was evaluated. Further, these members were molded using an epoxy resin and then a cycle test was conducted to evaluate the joint reliability. The results are shown in Table 4.

**[Table 3]**

| | Composition (mass%) | | | | | | | | Melting point (°C) | | Less than 50 µm particle percentage (%) | Wettabbility (Cu) surface) | Joint reliability |
|---|---|---|---|---|---|---|---|---|---|---|---|---|---|
| | Bi | Ag | Al | Sn | Zn | Cu | P | Ge | Solid phase | Liqid phase | | | |
| Example25^{.} | Balance | 0.6 | 0.1 | - | 0.01 | - | | | 269 | 269 | 99.7 | GOOD | 500 cycles |
| Example26 | Balance | 1 | 0.5 | 0.01 | - | - | - | - | 269 | 269 | 99.7 | GOOD | 500 cycles |
| Example27 | Balance | 5 | 1 | - | 0.3 | - | - | - | 269 | 300 | 98.9 | GOOD | 500 cycles |
| Example28 | Balance | 5 | 1 | 0.3 | - | - | - | - | 268 | 300 | 98.9 | GOOD | 500 cycles |
| Example29 | Balance | 15 | 1 | - | 3 | - | - | 0.001 | 265 | 360 | 98.3 | EXCELLENT | 500 cycles |
| Example30 | Balanoe | 15 | 1 | 3 | - | - | 0.001 | | 265 | 360 | 98.2 | EXCELLENT | 500 cycles |
| Example31 | Balance | 15 | 3 | 0.5 | 0.5 | 0.01 | - | - | 267 | 380 | 97.3 | GOOD | 700 cyeles |
| Example32 | Balance | 18 | 1 | - | 0.5 | 0.1 | - | 0.3 | 265 | 380 | 97.6 | EXCELLENT | 700 cycles |
| Example33 | Balance | 18 | 0.9 | 0.5 | - | 0.1 | 0.3 | - | 265 | 380 | 97.7 | EXCELLENT | 700 cyeles |
| Example34 | Balance | 15 | 3 | 0.5 | 0.5 | 0.1 | - | 0.05 | 267 | 380 | 97.9 | EXCELLENT | 700 cycles |
| Example35 | Balance | 15 | 3 | 0.5 | 0.5 | 0.1 | 0.05 | - | 267 | 380 | 97.2 | EXCELLENT | 700 cycles |
| Example36 | Balance | 15 | 3 | - | 0.5 | 1 | - | 0.05 | 269 | 380 | 97.1 | EXCELLENT | 700 cycles |
| Example37 | Balance | 15 | 3 | 0.5 | - | 1 | 0.05 | - | 267 | 380 | 97.2 | EXCELLENT | 700 cycles |

**[Table 4]**

| | Composition (mass%) | | | | | | | | Melting point (°C) | | Less than 50µm particle percentage (%) | Wettability (Cu surface) | Joint reliability |
|---|---|---|---|---|---|---|---|---|---|---|---|---|---|
| | Bi | Ag | Al | Sn | Zn | Cu | P | Ge | Solid phase | Liqid phase | | | |
| Comparative Example17 | Balance | 5 | 1 | - | - | - | - | - | 269 | 300 | 98.8 | POOR | Less than 500 cycles (joint failure) |
| Comparative Example18 | Balance | 5 | 1 | - | 0.005 | | | - | 269 | 300 | 98.8 | POOR | Less than 500 cycles (joint failure) |
| Comparative Example19 | Balance | 5 | 1 | 0.005 | - | - | | | 269 | 300 | 98.7 | POOR | Less than 500 cycles (joint failure) |
| Comparative Example20 | Balance | 15 | 1 | - | 4 | - | - | - | 262 | 360 | 96.4 | POOR | Less than 500 cycles (joint failure) |
| Comparative Example21 | Balance | 15 | 1 | 4 | | 1.5 | | - | 262 | 360 | 96.2 | POOR | Less than 500 cycles (joint failure) |
| Comparative Example22 | Balance | 0.5 | 0.1 | - | 0.01 | | | 0.3 | 262 | 262 | 99.3 | GOOD | Less than 500 cycles (crack) |
| Comparative Example23 | Balance | 0.6 | 0.05 | | 0.01 | - | 0.3 | - | 262 | 262 | 99.2 | GOOD | Less than 500 cycles (crack) |
| Comparative Example24 | Balance | 15 | 0.5 | | 0.01 | - | - | 0.001 | 262 | 360 | 98.3 | GOOD | Less than 500 cycles (crack) |
| Comparative Example25 | Balance | 5 | 3 | 0.01 | - | - | 0.001 | - | 269 | 390 | 96.6 | POOR | Less than 500 cycles (joint failure) |
| Comparative Example26 | Balance | 0.5 | 0.1 | - | 0.01 | 0.05 | - | 0.001 | 262 | 262 | 90.6 | GOOD | Less than 500 cycles (crack) |
| Comparative Example27 | Balance | 5 | 3 | 0.01 | - | 0.05 | 0.001 | - | 269 | 390 | 96.5 | POOR | Less than 500 cycles (joint failure) |
| Comparative Example28 | Balance | 18.3 | 1 | - | 0.01 | - | - | 0.001 | 262 | 400 | 97.6 | POOR | Less than 500 cycles (joint failure) |
| Comparative Example29 | Balance | 10 | 4 | 0.01 | - | 0.05 | 0.5 | - | 269 | 450 | 96.2 | POOR | Less than 500 cycles (joint failure) |
| Comparative Example30 | Balance | 18 | 1 | 1 | - | 0.5 | | 0.5 | 265 | 400 | 95.8 | POOR | Less than 500 cycles (joint failure) |

### Evaluation

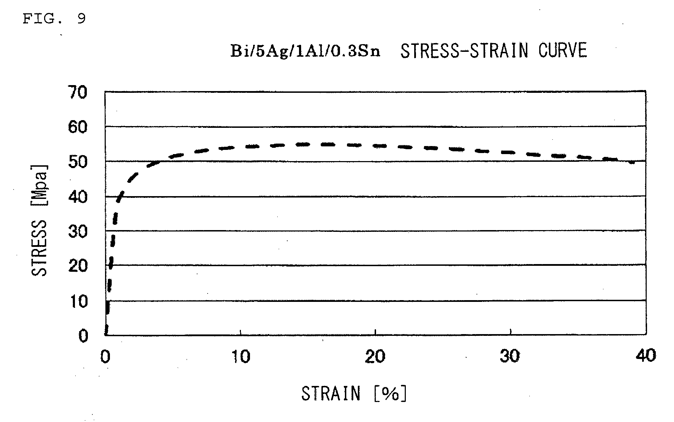

For Examples 25 to 37, as shown in Table 3, the content of Al was 0.1 to 3 mass%, and the content ratio (X) of Al to Ag was in a range of 1/20≤X≤1/2. These Examples were confirmed to have solidus temperatures of 265°C or more, as typified by Example 28 shown in Fig. 5. Also, by cross-sectional observation, it was confirmed that 97% or more of the particles of the added materials and the particles of an intermetallic compound formed therefrom in the solder wire had diameters of less than 50 µm. Further, these Examples were confirmed to have elongations of 15% or more and to have improved brittleness, as typified by Example 28 shown in Fig. 9.

Examples 25 to 37 contained Sn or Zn. Thus, even when these Examples were die-bonded to lead frames having a Ni surface, over which a solder wet and spread poorly, SnorZnproducedaninterfacial reaction with Ni. As a result, these Examples wet and spread well and improved wettability. Examples 25 to 30 were evaluated as "good" for joint reliability since no crack occurred in the chip or joint at 500 cycles, which is a smaller number of cycles. The reason is that these Examples contained Sn or Zn and thus wet and spread surely; and the solders and lead frames were joined together with sufficient strength and thus sufficient reliability was maintained.

Examples 31 to 37 contained Sn or Zn, as well as Cu and thus fined the structures and improved reliability. These Examples were evaluated as "good" for joint reliability since no crack occurred in the chip or joint even in temperature cycle tests of 700 cycles, which is a larger number of cycles.

Examples 29, 30, and 32 to 37 contained Sn or Zn, as well as P or Ge, which allowed to the solder to wet and spread much better. Thus, even when these Examples were die-bonded to lead frames having a Ni surface, over which a solder wet and spread poorly, Sn or Zn produced an interfacial reaction with Ni due also to the effect of P or Ge. As a result, these Examples wet and spread much better and were evaluated as "excellent" for wettability. For the mechanical properties, any of Examples 25 to 37 exhibited high strength in the scope of the added elements Further, these Examples could be continuously supplied by a die bonder without breaking a wire.

Then, parts of samples obtained by molding these Examples were each mounted on a board at 260°C five times and then it was checked whether an abnormality existed in the chip or joint. As a result, in any case, any abnormality was not found, nor was a conspicuous void identified. Thus, it was confirmed that the areas joined using the solder alloys of the present invention for Ni-plated electronic components were maintained without melting even when held at a reflow temperature of 260°C for 10 seconds five times or so.

On the other hand, Comparative Examples 17 to 21 did not contain any of Sn and Zn, or contained Sn or Zn in amounts departing from the upper or lower limit of the required amount, as shown in Table 4 . While these Comparative Examples surely wet and spread over Ag-surface lead frames, there was a sample which did not sufficiently wet or spread over a Ni-surface lead frame, over which a solder was less likely to surely wet and spread. A conceivable reason is that when Sn or Zn was added in a small amount, that element reacted with the Ni surface poorly and thus the solder wet and spread poorly; when Sn or Zn was added in a large amount, coarse particles were formed, and the cohesion thereof impaired the wetting spread of the solder.

Note that the solidus and liquidus of a conventional Bi/2. 5Ag eutectic solder alloy were 262 °C, which was below the melting point of Bi alone, 271°C, as shown in a phase diagram in Fig. 2. This conventional solder alloy was evaluated as "good" in a wettability test, but was evaluated as "poor" for joint reliability since it exhibited an elongation of as low as about 8%, as shown in Fig. 6, due to not containing of Al and had brittle properties.

Comparative Examples 22 to 30 contained Bi, Ag, and Al in amounts departing from the upper or lower limits of the required amounts, or had the content ratio of Al to Ag departing from the scope of the present invention. These Comparative Examples suffered a crack in the wire, or a joint failure, and the joint reliability test results were less than 500 cycles.

Thus, it can be said that any peel, void, or the like does not occur in an area joined using the solder alloy of the present invention for Ni-plated electronic components even during reflow, during which an electronic component is mounted on a board, and therefore any problem does not occur in the properties of the Ni-plated electronic component.

### Industrial Applicability

The Bi-based solder alloys of the present invention can be suitably used as preform solders or paste solders for Ag-plated electronic components, bare Cu frame electronic components, Ni-plated electronic components, and the like in place of high-temperature solders, such as Pb/5Sn. Particularly, these Bi-based solder alloys can be suitably used to join a chip in a semiconductor package, such as a power device or power module. Description of Reference Signs

- 1: chip
- 2: electrode
- 3: solder
- 4: lead frame island
- 5: lead frame
- 6: bonding wire
- 7: mold resin

## Claims

1. A Bi-based solder alloy that comprises Ag and Al, is substantially free of Pb, and has a Bi content of 80 mass% or more, a solidus of a melting point of 265°C or more, and a liquidus of 390°C or less, wherein
a content of Ag is 0.6 to 18 mass%,
a content of Al is 0.1 to 3 mass%,
the content of Al is 1/20 to 1/2 of the content of Ag, and particles comprising a Ag-Al intermetallic compound are dispersed in the solder alloy.

2. A Bi-based solder alloy that comprises Ag and Al, is substantially free of Pb, and has a Bi content of 80 mass% or more, a solidus of a melting point of 265°C or more, and a liquidus of 390°C or less, wherein
a content of Ag is 0.6 to 18 mass%,
a content of Al is 0.1 to 3 mass%,
the content of Al is 1/20 to 1/2 of the content of Ag, and particles comprising a Ag-Al intermetallic compound are dispersed in the solder alloy, the Bi-based solder alloy further comprising one or more of P and Ge in 0.001 to 0.3 mass%.

3. A Bi-based solder alloy that comprises Ag and Al, is substantially free of Pb, and has a Bi content of 80 mass% or more, a solidus of a melting point of 265°C or more, and a liquidus of 390°C or less, wherein
a content of Ag is 0.6 to 18 mass%,
a content of Al is 0.1 to 3 mass%,
the content of Al is 1/20 to 1/2 of the content of Ag, and particles comprising a Ag-Al intermetallic compound are dispersed in the solder alloy, the Bi-based solder alloy further comprising one or more of Sn and Zn in 0.01 to 3 mass%.

4. The Bi-based solder alloy of any one of Claims 1 to 3, wherein 97 volume% or more of particles with respect to a total volume of all the particles have diameters of less than 50 µm.

5. The Bi-based solder alloy of any one of Claims 1 to 3, wherein the content of Al is 1/15 to 1/4 of the content of Ag.

6. The Bi-based solder alloy of any one of Claims 1 to 3, further comprising one or more selected from Te, Ni, and Cu in 0.01 to 1 mass%.

7. The Bi-based solder alloy of Claim 3, further comprising P or Ge in 0.001 to 0.3 mass%.

8. The Bi-based solder alloy of any one of Claims 1 to 3,
wherein
the particles comprising the Ag-Al intermetallic compound are dispersed in the alloy by pouring molten metal of the solder alloy into a mold and then quickly cooling and solidifying the molten metal to 260°C at a cooling speed of 3°C/sec or more.

9. A method for bonding an electronic component comprising bonding a Ag-plated electronic component, a bare Cu frame electronic component, or a Ni-plated electronic component using the Bi-based solder alloy of any one of Claims 1 to 8.

10. An electronic component-mounted board produced by mounting an electronic component using the Bi-based solder alloy of any one of Claims 1 to 8 at a reflow work peak temperature of 260 to 265°C.
